# EUROPEAN PATENT APPLICATION

(11) **EP 4 475 344 A1**
(43) Date of publication of application: **11.12.2024**
(21) Application number: 23177155.1
(22) Date of filing: 05.06.2023
(51) Int. Cl.: H01R 12/70, H01R 12/71

(54) **CONNECTOR AND ELECTRONIC ASSEMBLY**

(71) Applicant: Magna Electronics Sweden AB, 447 37 Vårgårda (SE)
(72) Inventor: HOMUTESCU, Adrian, 700051 Iasi (RO); CAZACU, Vlad, 700051 Iasi (RO)
(74) Representative: Reichert & Lindner Partnerschaft Patentanwälte

(57) **Abstract**

A connector (1) for electrically connecting to a circuit carrier (60) in an electronic assembly (100) has at least one stake (13) for thermoplastic staking connected to the connector (1). The at least one stake (13) may be an integral part of a connector body (11). One or more parts (111, 112) of a housing (110) of the electronic assembly (100) may be mechanically connected to the connector (1) and the circuit carrier (60) by thermoplastic staking at the at least one stake (13).

## Description

The invention relates to a connector for electrically connecting to a circuit carrier and to an electronic assembly with a circuit carrier and such a connector.

Electronic devices, which are widely used in modern technology, very often are based on a circuit carrier, e.g., a printed circuit board (PCB), on which various types of components are mounted. These components include purely electronic components, for instance, transistors and resistors, functional components like light-emitting diodes (LEDs), photocathodes, cameras, and also connectors for establishing an electrical connection between the electronic device, more precisely circuitry on the circuit carrier, and setups external to the electronic device. Electronic devices further may include a housing of one or more parts or be mounted into the housing of some encompassing system.

While for electronic components soldering is a typically used and sufficient method of connection to the circuit carrier, connectors often require additional mechanical fixation on the circuit carrier. Additionally, the circuit carrier has to be fixed in a housing.

Fixing the circuit carrier to the housing is often done by screws. A disadvantage often encountered if screws are used is that a screw exerts stress on the circuit carrier in the vicinity of the screw, which may lead to local deformations of the circuit carrier, which in turn may negatively impact other components on the circuit carrier. Furthermore, screws require space on the circuit carrier, which in many applications is a scarce resource.

It is an object of the invention to overcome the above problems associated with mechanical fixation in electronic assemblies.

This object is achieved by a connector according to claim 1, and by an electronic assembly according to claim 4. The dependent claims refer to advantageous embodiments.

The connector according to the invention has one or more electric contacts for electrically connecting to a circuit carrier, more precisely to circuitry on the circuit carrier. The circuit carrier may be a printed circuit board, but the invention is not limited thereto. The connector also has a connector body for mechanically holding the one or more electric contacts. According to the invention, the connector has at least one stake for thermoplastic staking; the at least one stake is connected to the connector body.

In this way, the connector can be mechanically fixed to the circuit carrier, using thermoplastic staking. At the same time, the at least one stake can, prior to completion of the thermoplastic staking, function as a positioning pin, cooperating with at least one hole in the circuit carrier to correctly position the connector on the circuit carrier. Reliable positioning and fixing of the connector can be achieved with a connector according to the invention; space is saved, because holes on the circuit carrier for the at least one stake serve the double purpose of positioning and fixing. No screws, and correspondingly no extra holes for screws in the circuit carrier, are required. There also is no stress from screws exerted on the circuit carrier.

In an embodiment, the at least one stake forms an integral part of the connector body. The connector body may be injection-moulded from a thermoplastic material. In this way, in particular, the connector with the at least one stake as an integral part of the connector body may be easily fabricated. The connector according to the invention is easily handled and simplifies mounting of electronic assemblies it is used in.

An electronic assembly according to the invention includes a circuit carrier and a connector according to the invention as described above. The one or more electric contacts of the connector are electrically connected to the circuit carrier, more precisely to circuitry on the circuit carrier. The connector body is mechanically connected to the circuit carrier by thermoplastic staking at the at least one stake. For this purpose, a hole is provided in the circuit carrier for each of the at least one stake.

In an embodiment the electronic assembly additionally includes a housing. The housing may be a single part but may also comprise two or more parts. The connector body is mechanically connected to at least one part of the housing by thermoplastic staking at the at least one stake. In particular, the housing may include a main part and a cover part, wherein the circuit carrier, the connector body, the main part and the cover part are mechanically connected by thermoplastic staking at the at least one stake. Here the connector not only serves as a connector and is fixed to the circuit carrier and into the housing by thermoplastic staking, but by the at least one stake connected to the connector, the connector also functions as a mechanical connecting element for parts of the housing and for the circuit carrier.

In an embodiment the electronic assembly includes more than one connector according to the invention. Each of the connectors also functions as a mechanical connecting element at various portions of the housing of the electronic assembly.

Below the invention and its advantages will be described with reference to the accompanying drawings.
- Figure 1: shows a prior art electronic assembly.
- Figure 2: is a further view of the prior art electronic assembly of Fig. 1.
- Figure 3: shows a prior art connector.
- Figure 4: shows the prior art connector of Fig. 3 connected to a circuit carrier.
- Figure 5: is a further view of prior art connector and circuit carrier shown in Fig. 4.
- Figure 6: shows a connector according to the invention.
- Figure 7: is a different view of the connector according to the invention shown in Fig. 6.
- Figure 8: shows an electronic assembly according to the invention.
- Figure 9: is a further view of an electronic assembly according to the invention.
- Figure 10: shows an electronic assembly according to the invention, with housing.
- Figure 11: is a further view of the electronic assembly according to the invention shown in Fig. 10.
- Figure 12: is a further view of the electronic assembly according to the invention shown in Fig. 10.
- Figure 13: is a further view of the electronic assembly according to the invention shown in Fig. 10.
- Figure 14: shows an electronic assembly according to the invention.
- Figure 15: is a further view of the electronic assembly shown in Fig. 14.
- Figure 16: is a section view of an electronic assembly according to the invention.
- Figure 17: is an isolated view of a connector according to the invention after thermoplastic staking.
- Figure 18: shows an electronic assembly according to the invention.
- Figure 19: shows an electronic assembly according to the invention.
- Figure 20: is a further view of an electronic assembly according to the invention shown in Fig. 19.
- Figure 21: is a section view of an electronic assembly according to the invention shown in Fig. 19.

The figures only show examples of how the invention can be implemented. Therefore, the figures are not to be taken as a limitation of the invention to the examples shown. The following figures show examples of the invention in the context of a camera module of a driver monitoring system in the automotive sector. The invention, however, is limited neither to camera modules nor to the automotive sector.

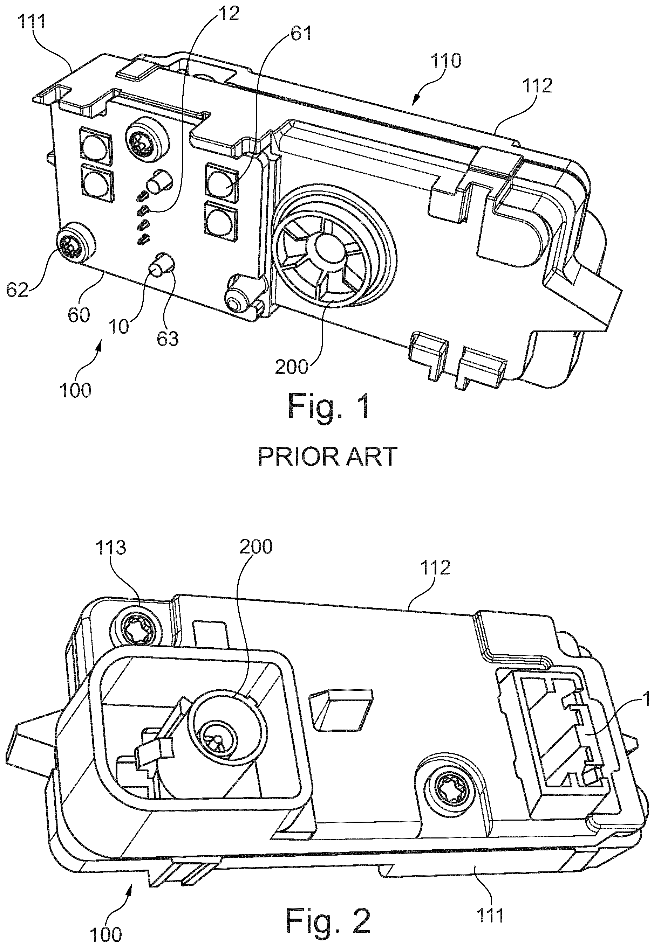

**Fig. 1** shows a prior art electronic assembly 100, which here is a camera module, with camera 200. The electronic assembly 100 has a housing 110, with a main part 111 and a cover part 112. Furthermore, the electronic assembly 100 includes a circuit carrier 60, attached by screws 62 to main part 111 of housing 110, and carrying LEDs 61. Aligning pins 10 of a connector (mostly covered here by circuit carrier 60) pass through holes 63 in circuit carrier 60 for properly aligning connector and circuit carrier 60. Also shown are electric contacts 12 of the connector, which here are in electrical connection with the circuit carrier 60, more precisely with circuitry (not shown) on the circuit carrier 60. Obviously, screws 62 occupy space on the circuit carrier 60.

**Fig. 2** is a different view of the prior art electronic assembly 100 shown in Fig. 1. Cover part 112 is attached to main part 111 by screws 113. The connector 1 is visible here, as is camera 200.

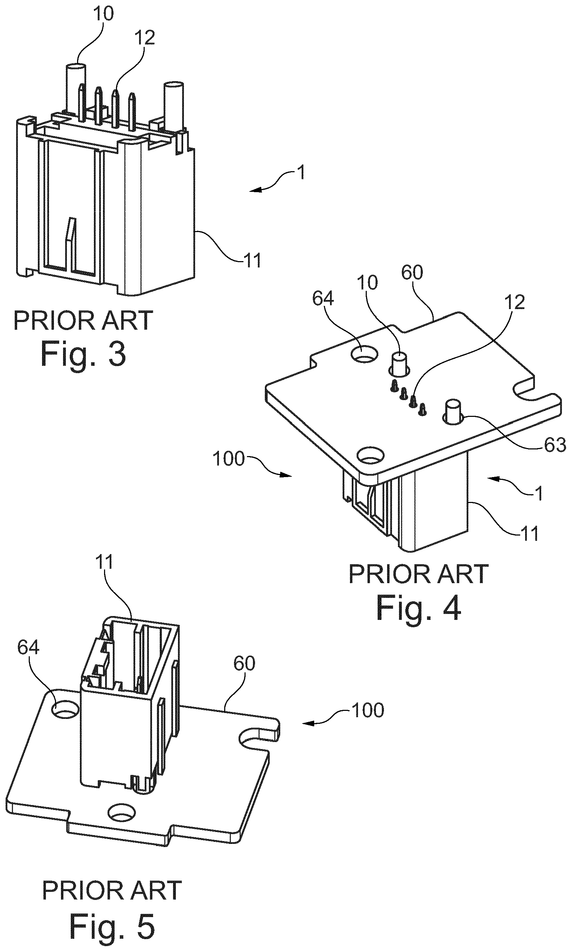

**Fig. 3** shows a prior art connector 1, with connector body 11, aligning pins 10, and electric contacts 12.

**Fig. 4** shows a prior art electronic assembly 100, including a prior art connector 1 as shown in Fig. 3 and a circuit carrier 60. Aligning pins 10 of connector 1 pass through holes 63 in the circuit carrier 60. Electric contacts 12 of connector 1 are in electrical connection with circuitry (not shown) on the circuit carrier 60. Also shown are holes 64 in the circuit carrier for screws to attach the circuit carrier 60 to a housing.

**Fig. 5** is a further view of the prior art electronic assembly 100 shown in Fig. 4. Shown are the connector body 11 attached to circuit carrier 60 and holes 64 for screws.

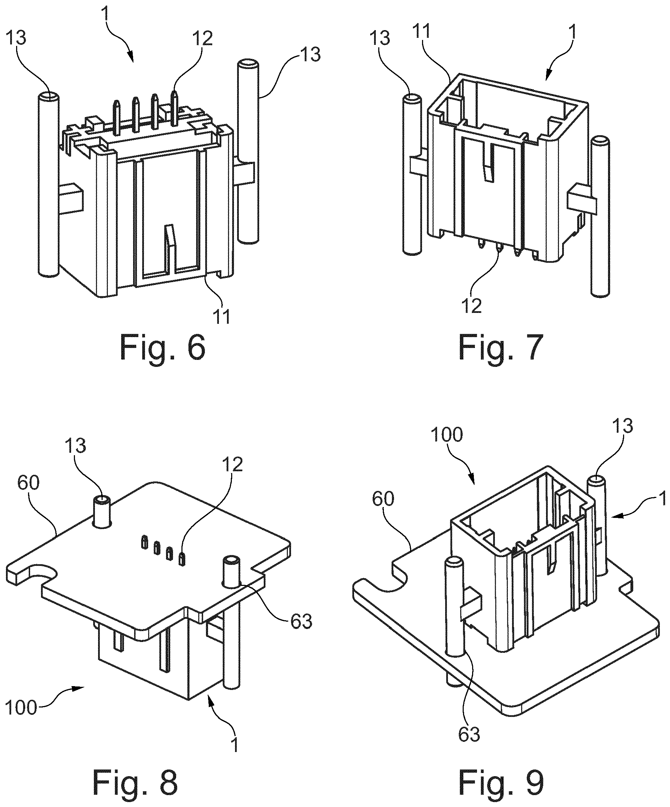

**Fig. 6** shows a connector 1 according to the invention, with connector body 11 and electric contacts 12. Two stakes 13 for thermoplastic staking are connected to the connector body 11, here more precisely form an integral part of connector body 11. Connector body 11 together with stakes 13 has been fabricated by injection-moulding from a thermoplastic material.

**Fig. 7** is a further view of the connector 1 according to the invention shown in Fig. 6. The elements shown with reference signs have been discussed in the context of Fig. 6.

**Fig. 8** shows an electronic assembly 100 according to the invention including a circuit carrier 60 and a connector 1 according to the invention as shown in Figs. 6 and 7. Stakes 13 protrude through holes 63 in circuit carrier 60. Electric contacts 12 are in electrical connection with circuitry (not shown) on the circuit carrier 60. In cooperation with holes 63 the stakes 13 assure correct alignment between circuit carrier 60 and connector 1. The stakes 13 passed through holes 63 also are used for thermoplastic staking. Here, a stage prior to the thermoplastic staking is shown.

**Fig. 9** is a further view of the electronic assembly 100 according to the invention shown in Fig. 8. The elements shown with reference signs have been discussed in the context of Fig. 8.

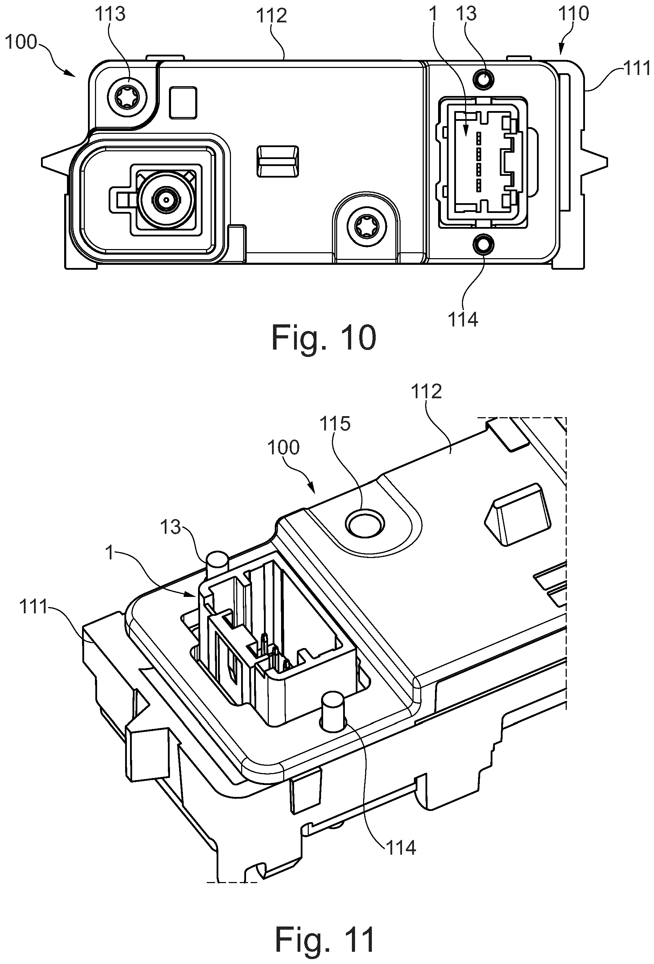

**Fig. 10** shows an electronic assembly 100 according to the invention, with housing 110, the housing 110 having a main part 111 and a cover part 112. Cover part 112 is attached to main part 111 by screws 113. Also visible is connector 1 with stakes 13. The stakes 13 here protrude through holes 114 in cover part 112. Shown is a stage prior to thermoplastic staking.

**Fig. 11** is a further view of the electronic assembly 100 according to the invention shown in Fig. 10. Visible here is a hole 115 in cover part 112 for a screw 113 (see Fig. 10) to attach cover part 112 to main part 111. Also shown is connector 1 with stakes 13 protruding through holes 114. Shown is a stage prior to thermoplastic staking.

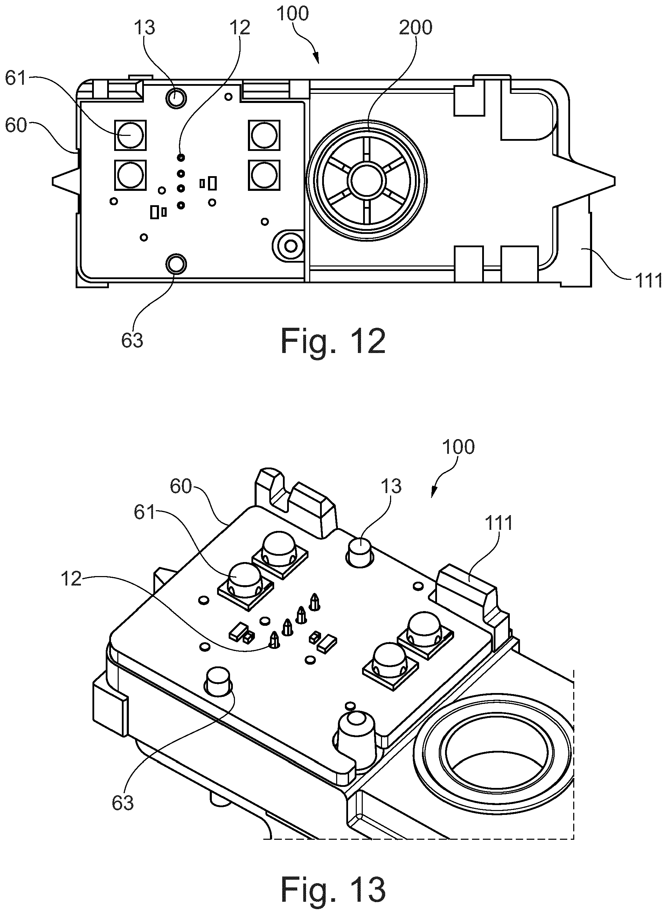

**Fig. 12** is a further view of the electronic assembly 100 according to the invention shown in Fig. 10. Shown are the main part 111 of the housing and camera 200. Circuit carrier 60 includes LEDs 61; circuitry (not shown) on the circuit carrier 60 is in electrical connection with electric contacts 12 of the connector (here mainly covered by circuit carrier 60). Stakes 13 of the connector protrude through holes 63 in the circuit carrier 60. Shown is a stage prior to thermoplastic staking.

**Fig. 13** is a further view of the electronic assembly 100 according to the invention shown in Fig. 10. Shown is a stage prior to thermoplastic staking. The elements shown with reference signs have been discussed in the context of Fig. 12.

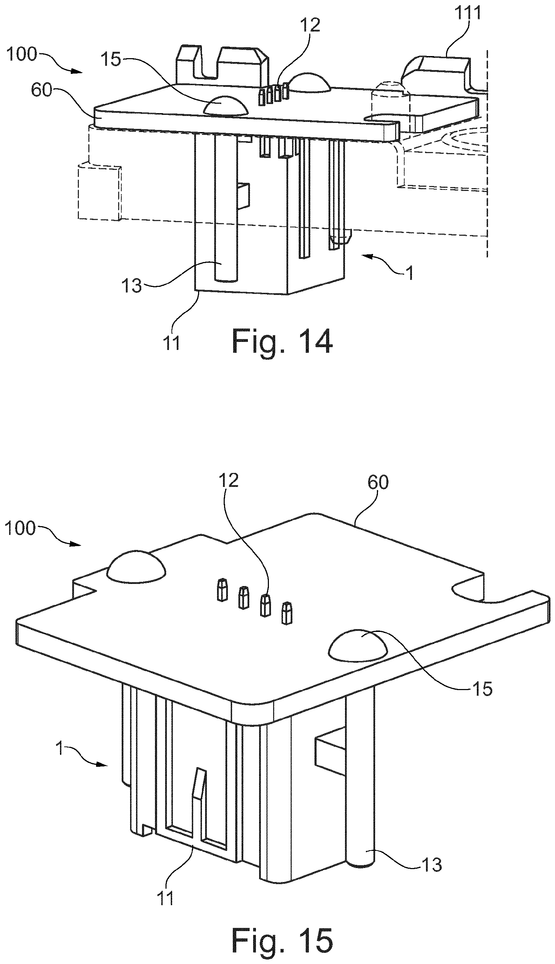

**Fig. 14** shows an electronic assembly 100 according to the invention. The electronic assembly 100 includes circuit carrier 60 and connector 1 with connector body 11, electric contacts 12, and stakes 13. Main part 111 of a housing is also shown. The electric contacts 12 are in electrical connection with circuitry (not shown) on the circuit carrier 60. Shown is a stage after thermoplastic staking. Ends 15 of stakes 13 protruding through holes 63 (see Fig. 13) have been deformed by thermoplastic staking so that the connector 1 is attached to the circuit carrier 60.

**Fig. 15** is a further view of the electronic assembly 100 shown in Fig. 14. The main part of the housing is not shown. The elements shown with reference signs have been discussed in the context of Fig. 14.

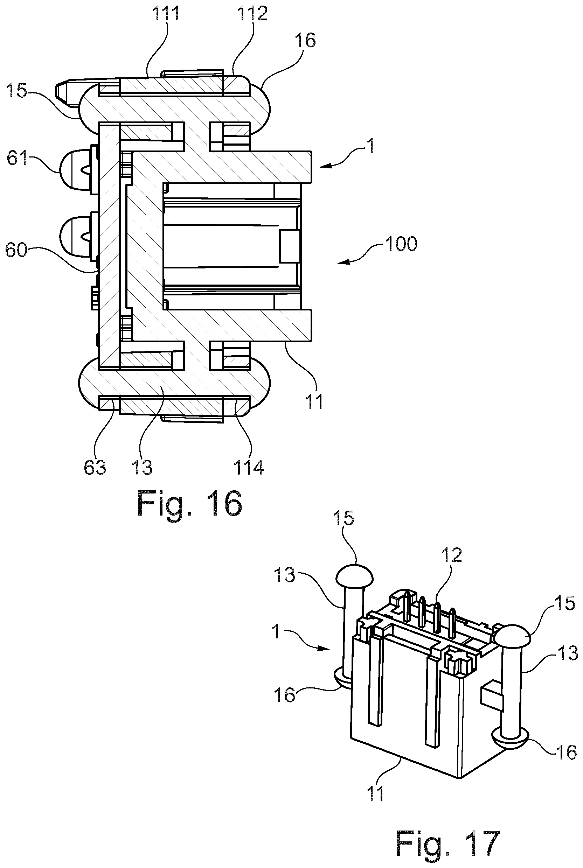

**Fig. 16** is a section view of an electronic assembly 100 according to the invention. The electronic assembly 100 includes a connector 1 with connector body 11 and stakes 13, circuit carrier 60, main part 111 and cover part 112 of a housing. Circuit carrier 60 carries LEDs 61. Here a stage after thermoplastic staking is shown. Note that in the example shown here, both ends 15 of stakes 13 passed through holes 63 in the circuit carrier 60 and ends 16 of stakes 13 passed through holes 114 in cover part 112 have been deformed by thermoplastic staking. In this way, by thermoplastic staking, the connector 1 according to the invention binds circuit carrier 60, main part 111 of the housing and cover part 112 of the housing together. By the same step, the connector 1 itself is attached to the electronic assembly 100.

**Fig. 17** shows a connector 1 according to the invention after thermoplastic staking in an isolated view. In the state shown the connector 1 is attached to an electronic assembly 100 as shown in Fig. 16 and cannot be removed without destroying the electronic assembly. The connector 1 has connector body 11 and stakes 13. Both ends 15 and ends 16 of stakes 13 have been deformed by thermoplastic staking. Electric contacts 12 are also shown.

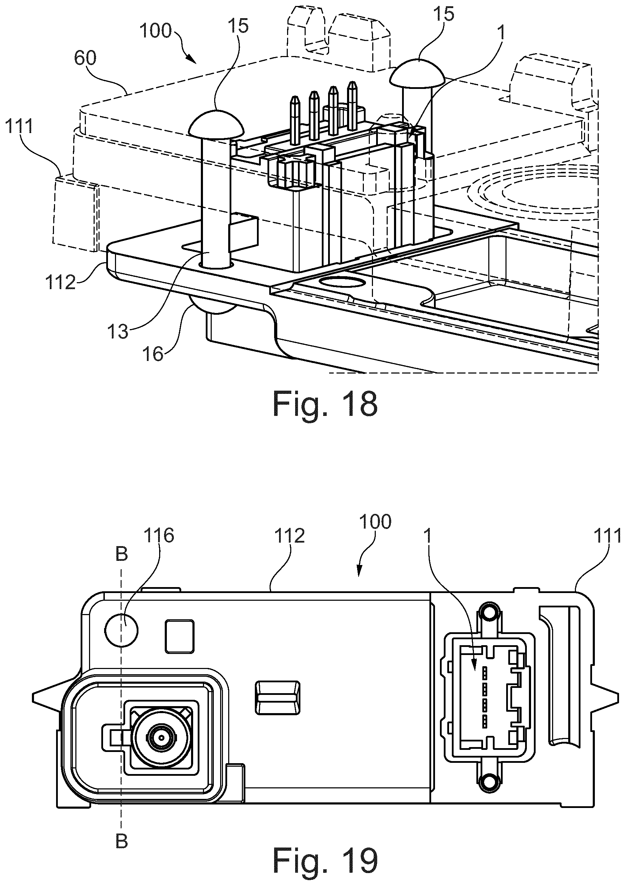

**Fig. 18** shows an electronic assembly 100 according to the invention. A connector 1 according to the invention is shown within the electronic assembly 100 in a stage after thermoplastic staking. Both ends 15 and 16 of stakes 13 have been deformed by thermoplastic staking. The connector 1 binds circuit carrier 60, main part 111 and cover part 112 of a housing together.

**Fig. 19** shows an electronic assembly 100 according to the invention. Connector 1, here in a stage prior to thermoplastic staking, only interferes with the main part 111 of the housing and the circuit carrier (here covered by main part 111), not with the cover part 112. So, after thermoplastic staking, the connector 1 will bind the circuit carrier to the main part 111 and will itself be attached to the electronic assembly 100, but the connector 1 will not attach the cover part 112 to the electronic assembly 100. For this purpose, here a separate stake 116 is provided.

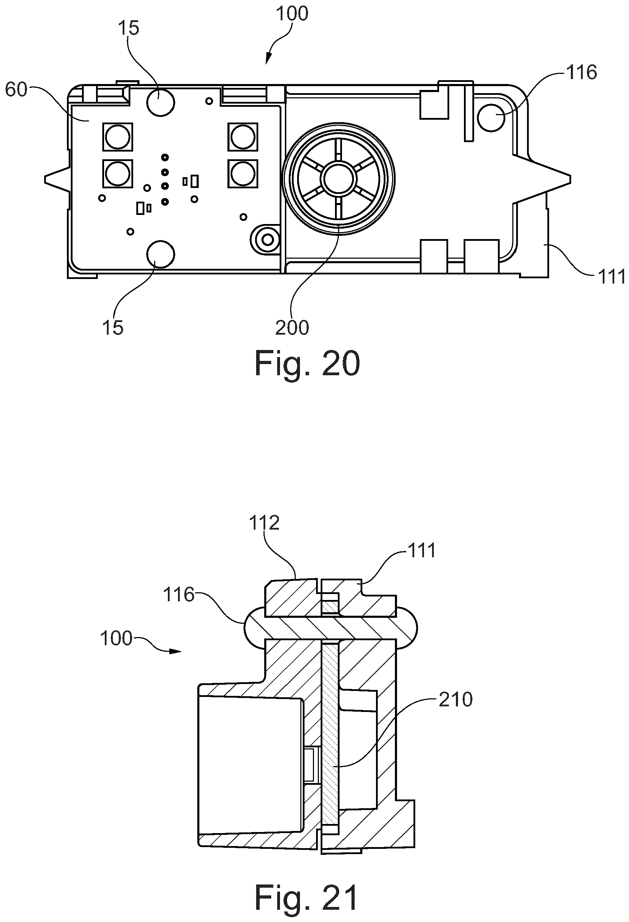

**Fig. 20** is a further view of the electronic assembly 100 shown in Fig. 19. Shown are the ends 15 of the stakes of the connector after thermoplastic staking, binding circuit carrier 60 to the main part 111 of the housing. Also shown is stake 116, binding cover part 112 (see Fig. 19) to main part 111. Camera 200 protrudes from the main part 111.

**Fig. 21** is a sectional view of the electronic assembly 100 shown in Figs. 19 and 20, the section is along the line B-B in Fig. 19. Stake 116 binds main part 111, cover part 112 and a separate circuit carrier 210 for the camera 200 (see Fig. 20) together.

### List of Reference Signs

- 1: connector
- 10: aligning pin
- 11: connector body
- 12: electric contact
- 13: stake
- 15: end (of stake)
- 16: end (of stake)
- 60: circuit carrier
- 61: LED
- 62: screw
- 63: hole
- 64: hole
- 100: electronic assembly
- 110: housing
- 111: main part (housing)
- 112: cover part (housing)
- 113: screw
- 114: hole
- 115: hole
- 116: stake
- 200: camera
- 210: circuit carrier (camera)

## Claims

1. Connector (1) with
one or more electric contacts (12) for electrically connecting to a circuit carrier (60);
a connector body (11) for mechanically holding the one or more electric contacts (12);
**characterized by**
at least one stake (13) for thermoplastic staking connected to the connector body (11).

2. Connector (1) according to claim 1, wherein the at least one stake (13) forms an integral part of the connector body (11).

3. Connector (1) according to claim 1 or 2, wherein the connector body (11) is injection-moulded from a thermoplastic material.

4. Electronic assembly (100) including
a circuit carrier (60);
a connector (1) according to one of the claims 1 to 3,
the one or more electric contacts (12) of the connector (1) electrically connected to the circuit carrier (60),
the connector body (11) mechanically connected to the circuit carrier (60) by thermoplastic staking at the at least one stake (13).

5. Electronic assembly (100) according to claim 4, additionally including a housing (110), wherein the connector body (11) is mechanically connected to at least one part (111, 112) of the housing (110) by thermoplastic staking at the at least one stake (13).

6. Electronic assembly (100) according to claim 5, the housing (110) including a main part (111) and a cover part (112), wherein the circuit carrier (60), the connector body (11), the main part (111) and the cover part (112) are mechanically connected by thermoplastic staking at the at least one stake (13).

7. Electronic assembly (100) according to claim 5, wherein the electronic assembly (100) includes more than one connector (1) according to one of the claims 1 - 3, each connector (1) mechanically connecting parts of the housing.
